(19) Europäisches Patentamt
European Patent Office
Office européen des brevets

(11) **EP 2 449 392 B1**

(12) **FASCICULE DE BREVET EUROPEEN**

(45) Date de publication et mention de la délivrance du brevet:
**03.12.2014 Bulletin 2014/49**

(21) Numéro de dépôt: **10726530.8**

(22) Date de dépôt: **30.06.2010**

(51) Int Cl.:
*G01R 31/36* *(2006.01)*     *H01M 10/42* *(2006.01)*
*G01R 35/00* *(2006.01)*

(86) Numéro de dépôt international:
**PCT/EP2010/059287**

(87) Numéro de publication internationale:
**WO 2011/000872 (06.01.2011 Gazette 2011/01)**

(54) **PROCEDE DE CALIBRATION D'UN ACCUMULATEUR ELECTROCHIMIQUE**

VERFAHREN ZUR KALIBRIERUNG EINER ELEKTROCHEMISCHEN BATTERIE

METHOD FOR CALIBRATING AN ELECTROCHEMICAL BATTERY

(84) Etats contractants désignés:
**AL AT BE BG CH CY CZ DE DK EE ES FI FR GB GR HR HU IE IS IT LI LT LU LV MC MK MT NL NO PL PT RO SE SI SK SM TR**

(30) Priorité: **01.07.2009 FR 0903258**

(43) Date de publication de la demande:
**09.05.2012 Bulletin 2012/19**

(73) Titulaire: **Commissariat à l'Énergie Atomique et aux Énergies Alternatives
75015 Paris (FR)**

(72) Inventeurs:
• **MAMADOU, Kelli**
  **F-97200 Fort De France (FR)**
• **DELAILLE, Arnaud**
  **F-73000 Bassens (FR)**

(74) Mandataire: **Novaimo
Bâtiment Europa 2
310 avenue Marie Curie
Archamps Technopole
74166 Saint Julien en Genevois Cedex (FR)**

(56) Documents cités:
**WO-A2-02/42786      DE-A1-102008 004 368
JP-A- 10 289 734      US-A- 5 650 712
US-B1- 6 300 763**

• **DURR M ET AL: "Dynamic model of a lead acid battery for use in a domestic fuel cell system" JOURNAL OF POWER SOURCES, ELSEVIER SA, CH LNKD- DOI:10.1016/J.JPOWSOUR. 2005.12.075, vol. 161, no. 2, 27 octobre 2006 (2006-10-27), pages 1400-1411, XP025084940 ISSN: 0378-7753 [extrait le 2006-10-27]**

**Description**

L'invention concerne un procédé de calibration d'un accumulateur électrochimique, ainsi qu'un procédé d'estimation de l'énergie disponible au sein d'un tel accumulateur. Elle concerne aussi tout dispositif ou système intégrant un accumulateur électrochimique dont la gestion est basée sur le procédé de calibration précédent.

Pour maîtriser le fonctionnement de tout appareil ou système intégrant au moins un accumulateur électrochimique, il est essentiel de connaître et maîtriser les performances d'un tel accumulateur, pour notamment gérer ses phases de charge et décharge et au final optimiser le fonctionnement de l'appareil ou du système. Il est en effet avantageux de connaître à tout instant l'état de l'accumulateur et de pouvoir prévoir si sa réserve énergétique est suffisante pour fournir une énergie demandée. Cela exige donc la connaissance de l'énergie disponible de manière dynamique.

Une approche traditionnelle de l'état de la technique consiste d'une part à étudier le courant que peut fournir l'accumulateur, et d'autre part à estimer de manière découplée sa tension de sortie, pour en déduire sa puissance par le produit du courant et de la tension.

Dans cette approche traditionnelle, la loi de Peukert est appliquée, permettant de déterminer la capacité $C_{td\_mes}$ en Ampère-heure de l'accumulateur, qui correspond à la quantité de charge susceptible d'être fournie pendant un temps $t_{d\_mes}$ jusqu'à sa complète décharge, en fonction du courant constant de décharge imposé $I_{d\_imp}$, de la durée de décharge $t_{d\_mes}$ mesurée, en fonction d'une constante K et du coefficient de Peukert n, selon la relation suivante :

$$C_{td\_mes} = t_{d\_mes} \times I_{d\_imp} = K / (I_{d\_imp})^{n-1}$$

Ensuite, cette approche-traditionnelle est complétée par l'estimation de l'état de charge de l'accumulateur, appelé par sa dénomination anglo-saxonne « State Of Charge », et couramment plus simplement SOC. Ce paramètre de SOC représente la capacité disponible de l'accumulateur sur une échelle de 0 à 100%. La valeur de SOC est établie et connue pour différents régimes de décharge imposés, tout au long de la vie de l'accumulateur. Pour cela, des algorithmes itératifs sont basés sur la loi de Peukert, adaptée pour tenir compte de différents facteurs comme le vieillissement de l'accumulateur et la température. Cette approche est en pratique très difficile et imprécise car de nombreux facteurs influencent le SOC. De plus, le coefficient de Peukert n nécessite aussi une grande précision, de l'ordre de $10^{-3}$, pour approcher des résultats satisfaisants, ce qui exige des expérimentations complexes et très précises.

En parallèle, il est nécessaire de prédire les variations de la tension dans le temps aux bornes de l'accumulateur. Cette estimation est réalisée par calcul à l'aide d'un modèle.

Enfin, le produit du courant de décharge par la tension permet d'atteindre la puissance de décharge de l'accumulateur, dont l'intégration dans le temps permet d'en déduire l'énergie disponible.

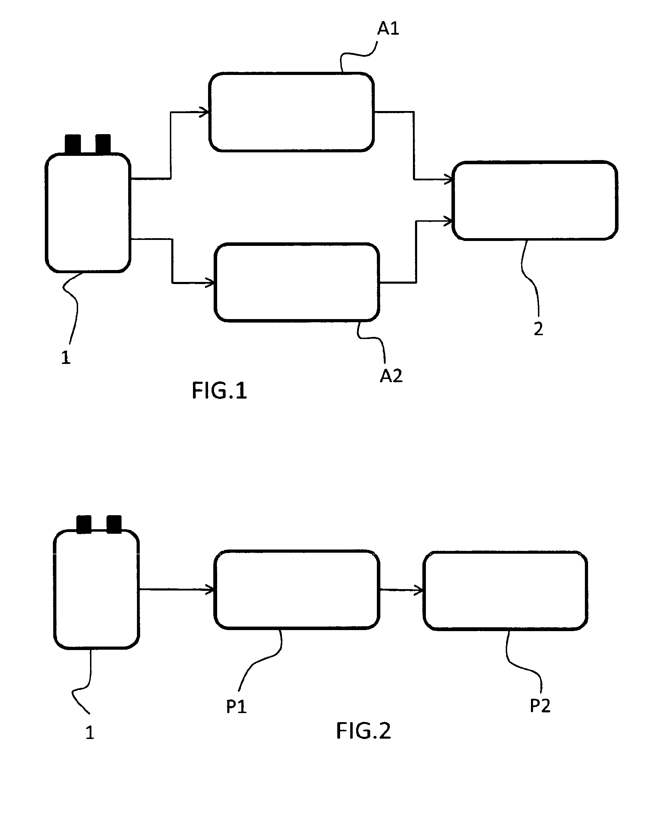

La figure 1 représente une telle approche conventionnelle, dans laquelle un accumulateur 1 est d'une part étudié par une première approche A1 comprenant l'étude de son courant de sortie, la détermination de la loi de Peukert et l'état de charge SOC, puis par une seconde approche A2 permettant de déterminer sa caractérisation électrique pour modéliser sa tension. Enfin, il est possible de calculer dans un dernier bloc 2 son énergie disponible pour différentes puissances de décharge.

Comme cela a été explicité précédemment, l'approche de l'état de la technique est très complexe à mettre en oeuvre et donc insatisfaisante. Elle entraîne une mauvaise maîtrise des systèmes intégrant un ou plusieurs accumulateur(s) électrochimique(s).

Les documents US5,650,712A, US6,300,763B1 et WO02/42786A2 divulguent d'autres approches de l'estimation de l'état de charge et de l'état d'énergie connues dans l'état de la technique.

Ainsi, un objet général de l'invention est de proposer une autre solution pour déterminer l'énergie disponible d'un accumulateur électrochimique.

A cet effet, l'invention repose sur un procédé de calibration d'un accumulateur électrochimique selon la revendication indépendante 1. Des exemples de réalisation avantageux sont définis dans les revendications dépendantes.

L'invention comprend une phase de modélisation de l'énergie disponible $E_d$ dans l'accumulateur électrochimique représentant l'énergie qui serait obtenue lors d'une décharge complète de l'accumulateur à partir d'une puissance de décharge donnée et d'un état initial d'énergie donné. Le procédé de calibration comprend aussi une première phase de mesures d'au moins une valeur d'énergie disponible $E_d$, comprenant une première étape de détermination d'au moins une valeur de puissance de décharge $P_d$ et une seconde étape de détermination d'au moins une valeur d'état d'énergie initial $SOE_0$ pour laquelle des mesures de calibration de l'énergie disponible sont à effectuer.

Le procédé de calibration comprend aussi une étape de mesure de la valeur d'énergie disponible dans l'accumulateur électrochimique comprenant la mise en oeuvre des sous-étapes suivantes :

-   chargement à charge pleine de l'accumulateur ;

- décharge de l'accumulateur à puissance constante, égale à la puissance nominale $P_N$ de l'accumulateur prédéterminée, jusqu'à une énergie déchargée définie par la valeur $(1-SOE_0) E_N$ où $E_N$ correspond à l'énergie nominale de l'accumulateur ;
- décharge totale de l'accumulateur à puissance constante égale à une puissance de décharge choisie $P_d$ de l'accumulateur ;
- mesure de l'énergie totale déchargée $E_d$ lors de l'étape précédente, soit directement, soit à partir du temps de décharge.

La première phase de mesures d'au moins une valeur d'énergie disponible $E_d$ comprend une première étape de détermination d'un nombre $n_p$ de valeurs de puissance de décharge $P_{di}$ supérieur à un et une seconde étape de détermination d'un nombre $n_{soe}$ de valeurs d'états d'énergie initial $SOE_{0j}$ supérieur à un.

Le nombre $n_p$ de valeurs de puissance de décharge $P_{di}$ peut être compris entre 5 et 15 et le nombre $n_{soe}$ de valeurs d'état d'énergie initial $SOE_{0j}$ peut être compris entre 4 et 12.

Les différentes valeurs de puissance de décharge $P_{di}$ déterminées peuvent être comprises dans une plage de puissance d'utilisation de l'accumulateur électrochimique, incluant une puissance nominale $P_N$ prédéterminée, et ces différentes valeurs de puissance peuvent être réparties uniformément ou réparties non uniformément, en plus grand nombre vers les fortes et/ou les faibles valeurs.

Le procédé de calibration d'un accumulateur électrochimique comprend une étape de mesures de valeurs d'énergie disponible dans l'accumulateur électrochimique comprenant la mise en oeuvre des sous-étapes suivantes, répétées successivement pour chacune des $n_{soe}$ valeurs d'état d'énergie initial $SOE_{0j}$ choisies :

- chargement à charge pleine de l'accumulateur ;
- décharge de l'accumulateur à puissance constante, égale à la puissance nominale $P_N$ de l'accumulateur prédéterminée, jusqu'à une énergie déchargée définie par la valeur $(1-SOE_{0j}).E_N$ où EN correspond à l'énergie nominale de l'accumulateur;
- décharge totale de l'accumulateur à puissance constante égale à une puissance de décharge choisie $P_{di}$ de l'accumulateur ;
- mesure de l'énergie totale déchargée $E_{dij}$ lors de l'étape précédente, soit directement, soit à partir du temps de décharge ;

et les sous-étapes précédentes peuvent être réitérées jusqu'à atteindre la mesure pour toutes les $n_p$ valeurs de puissance de décharge $P_{di}$ prédéfinies, avant la réitération pour une nouvelle valeur d'état d'énergie initial $SOE_{0j+1}$.

Le procédé de calibration peut comprendre une période de relaxation d'au moins dix minutes entre les deux premières sous-étapes puis après la dernière sous-étape.

Le procédé de calibration peut comprendre une quatrième étape de détermination de valeurs d'énergie disponible supplémentaires associées à des valeurs supplémentaires de couples de puissance de décharge et d'état d'énergie initial $(Pd ; SOE_0)$ de l'accumulateur déduites des valeurs mesurées par extrapolation/intrapolation, lors de la phase de modélisation (P2) de l'énergie disponible.

Le procédé de calibration peut comprendre un calcul d'une énergie disponible $E_d$ à une puissance de décharge donnée $P_d$ pour un état d'énergie initial $SOE_0$ de l'accumulateur par l'intermédiaire d'une régression de type exponentiel ou puissance, selon la formule :
$E_{d\ SOEoj} = a_j + b_j . exp(-T_j P_d)$ où $a_j$, $b_j$, $T_j$ sont des paramètres de régression exponentielle,
Ou selon la formule
$E_{d\ SOEoj} = K_j/ P_d^{(nj-1)}$ où $K_j$ et $n_j$ $(n_j >1)$ sont des paramètres de régression de type puissance.

Le procédé peut comprendre un calcul d'une énergie disponible $E_d$ à l'état d'énergie initial $SOE_0$ par une régression linéaire, ou linéaire par morceaux, à partir des paramètres de type exponentiel ou puissance de la régression précédente en fonction de l'état d'énergie initial.

Le procédé de calibration peut établir le calcul de l'énergie disponible $E_d$ d'un accumulateur en fonction de la puissance de décharge $P_d$ et de l'état d'énergie initial $SOE_0$ par la formule suivante :

$$E_d = a_j (SOE_0) + b_j (SOE_0) . exp [-τ_j (SOE_0) P_d]$$

Où $a_j$, $b_j$, $T_j$ sont des fonctions linéaires ou linéaires par morceaux dépendant de l'état d'énergie initial $SOE_0$.

L'invention porte aussi sur un procédé d'estimation de l'énergie disponible d'un accumulateur électrochimique, caractérisé en ce qu'il comprend l'application du procédé de calibration tel que défini précédemment.

L'invention porte aussi sur un dispositif comprenant au moins un accumulateur électrochimique, caractérisé en ce qu'il comprend un moyen d'estimation de l'énergie disponible mettant en oeuvre un procédé tel que décrit ci-dessus.

Ces objets, caractéristiques et avantages de la présente invention seront exposés en détail dans la description suivante d'un mode d'exécution particulier fait à titre non-limitatif en relation avec les figures jointes parmi lesquelles :

La figure 1 représente schématiquement la méthode d'évaluation de l'énergie disponible dans un accumulateur électrochimique selon l'état de la technique.

La figure 2 représente schématiquement la méthode d'évaluation de l'énergie disponible dans un accumulateur électrochimique selon l'invention.

La figure 3 représente un procédé de mesures de valeurs de calibration selon le mode d'exécution de l'invention.

La figure 4 représente une méthode d'extrapolation à partir des valeurs mesurées selon le mode d'exécution de l'invention.

La figure 5 représente des valeurs de calibration représentant l'énergie disponible en fonction de la puissance de décharge pour plusieurs valeurs d'état initial selon le mode d'exécution de l'invention.

L'invention repose sur le concept d'évaluer directement la quantité d'énergie disponible dans un accumulateur électrochimique, sans découplage du courant et de la tension.

Pour cela, l'invention repose sur un procédé de calibration d'un accumulateur électrochimique 1, qui permet de déterminer l'énergie disponible pour une puissance de décharge constante prédéfinie et pour un état de charge donné, selon une approche combinant une première phase P1 de mesures d'énergie et une seconde phase P2 de modélisation de l'énergie disponible permettant d'en déduire une estimation servant de calibration sans mesure directe, comme cela est schématiquement représenté sur la figure 2.

Avant de détailler les étapes importantes d'un mode d'exécution de l'invention, il convient au préalable d'apporter quelques définitions.

D'abord, une puissance ou énergie nominale de l'accumulateur, peut être définie selon les deux approches suivantes :

- la puissance nominale $P_N$ se trouve dans une plage de puissance d'utilisation recommandée par le fabricant de l'accumulateur, soit directement fournie par ce fabricant soit déduite par exemple d'une plage de courant fournie par ce fabriquant, par multiplication par une tension nominale fournie ; ou,
- la puissance nominale $P_N$ doit permettre d'effectuer des décharges les plus reproductibles possibles selon la technologie testée. Par exemple, cet objectif peut être atteint en déduisant la puissance nominale $P_N$ de la capacité nominale $C_N$ et de la tension nominale UN, par la formule $P_N = C_N.U_N/N$, N étant la durée de la décharge (en nombre d'heures).

Cette puissance nominale $P_N$ permet de déterminer une énergie nominale EN définie par l'énergie délivrée par l'accumulateur lorsqu'il est déchargé à puissance constante nominale $P_N$ depuis une pleine charge jusqu'à un état pleinement déchargé, pendant une durée nominale $t_N$ : ces données caractérisent le régime de décharge nominal.

Les états chargés et déchargés sont déterminés selon la technologie de l'accumulateur. Ils peuvent être obtenus à partir des recommandations du constructeur de l'accumulateur, et généralement à partir de tensions de seuil.

Enfin, un état d'énergie, dénommé « State Of Energy » SOE, est défini comme le rapport entre l'énergie $E_{d/PN}$ disponible dans l'hypothèse d'une décharge d'énergie dans les conditions nominales de l'accumulateur et l'énergie nominale EN, donc défini par la formule SOE = $E_{d/PN}$ / EN. Cette valeur de SOE est comprise entre 0 et 1, la valeur égale à 1 correspondant à un état d'énergie de l'accumulateur totalement chargé et la valeur égale à 0 comme un état totalement déchargé.

Le procédé de calibration en puissance de l'invention comprend une première étape E1 de caractérisation en puissance d'un accumulateur électrochimique 1. Cette étape comprend la détermination de plusieurs puissances de décharge $P_{di}$ dans la plage de puissance de fonctionnement de l'accumulateur, incluant donc la puissance nominale $P_N$. Le nombre $n_p$ de ces puissances de décharge doit représenter un bon compromis entre l'exigence d'obtenir suffisamment de valeurs mesurées sur des phases de décharge de l'accumulateur selon ces diverses puissances de décharge $P_{di}$, où i varie de 1 à $n_p$, comme cela sera explicité par la suite, et l'exigence de ne pas user l'accumulateur pour ne pas perturber des mesures ultérieures. Avantageusement, ce nombre $n_p$ de puissances de décharge choisies sera compris entre 5 et 15, ces valeurs étant incluses. Ces différentes puissances $P_{di}$ peuvent être choisies selon une répartition uniforme sur toute la plage d'utilisation de l'accumulateur ou de manière non uniforme, pour affiner le comportement vers les plus fortes et/ou les plus faibles puissances.

Le procédé de l'invention comprend une seconde étape E2 de détermination de plusieurs valeurs de $SOE_{0j}$, entre 0 et 1, représentant plusieurs états de charge en énergie de l'accumulateur. Le nombre $n_{soe}$ de ces valeurs choisies représente aussi un bon compromis pour obtenir un nombre de valeurs suffisant pour bien calibrer l'accumulateur sans toutefois entraîner son vieillissement prématuré. Un nombre compris entre 4 et 12 inclus est avantageux.

Le procédé de l'invention comprend ensuite la mise en oeuvre d'une troisième étape E3 de cycles de charges/décharges pour chacune des valeurs de puissance de décharge déterminées $P_{di}$ et pour chacune des valeurs de SOE déterminées $SOE_{0j}$, selon finalement un nombre $n_p \cdot n_{soe}$ de combinaisons possibles. Pour chaque couple de ces valeurs ($P_{di}$, $SOE_{0j}$), une énergie disponible $E_{dij}$ dans l'accumulateur est établie dans le cas d'une décharge à puissance constante $P_{di}$ à partir d'un état initial $SOE_{0j}$.

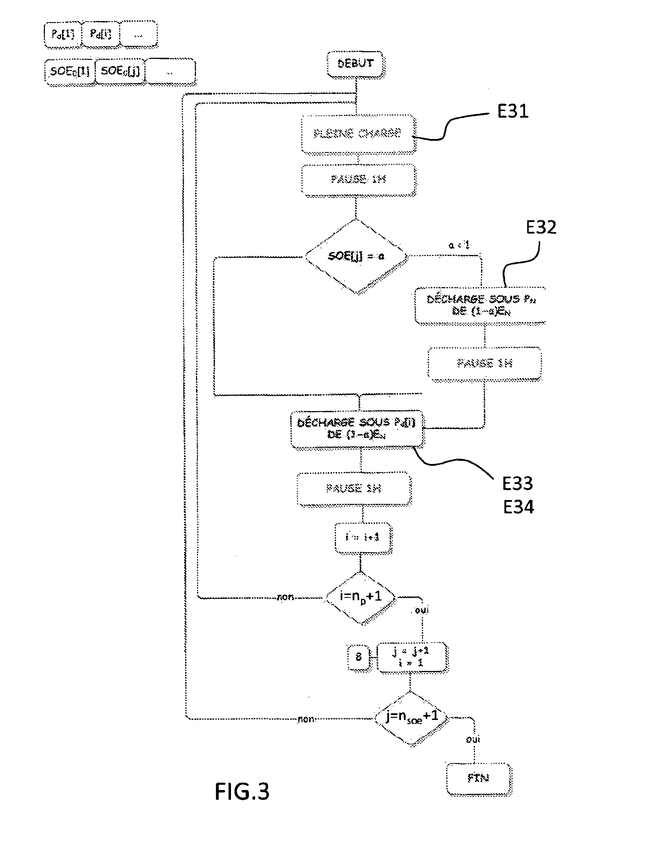

Selon le mode d'exécution de l'invention, cette étape de mesure E3, illustrée sur la figure 3, comprend la mise en oeuvre des étapes suivantes, répétées successivement pour chacune des $n_{soe}$ valeurs $SOE_{0j}$ (soit pour j variant de 1 à $n_{soe}$) :

E31 : chargement à pleine charge de l'accumulateur, selon une procédure recommandée par le fabricant et/ou la plus adaptée à la technologie de l'accumulateur concerné ;
E32 : décharge à puissance constante égale à la puissance nominale $P_N$ de l'accumulateur jusqu'à une énergie déchargée définie par $(1-SOE_{0j}) \times E_N$, permettant de l'amener à l'état initial $SOE_{0j}$ ;
E33 : décharge totale à puissance constante égale à $P_{di}$ de l'accumulateur ;
E34 : mesure de l'énergie totale déchargée lors de l'étape précédente, soit directement, soit indirectement comme par exemple à partir du temps de décharge.

Les étapes E31 à E34 sont réitérées successivement pour chacune des $n_p$ valeurs $P_{di}$ choisies (soit pour i variant de 1 à $n_p$). Entre les étapes E31 et E32 puis après l'étape E34, une période de relaxation suffisante est appliquée, d'au moins 10 minutes. Ensuite, l'ensemble de l'itération est reprise pour une prochaine valeur $SOE_{0j+1}$. Par exemple, la période de relaxation sera de 10 minutes pour une batterie Li-ion et supérieure à une heure pour une batterie au plomb.

Le procédé comprend ensuite une dernière étape E4 de calcul pour déduire des valeurs mesurées précédemment d'autres valeurs de calibration, comme pour obtenir l'énergie disponible $E_d$ ou l'état d'énergie tout le long d'un profil de puissance imposé à l'accumulateur.

L'algorithme précédent a été illustré par une double itération, chacune des $n_p$ valeurs $P_{di}$ étant itérée pour chacune des $n_{soe}$ valeurs $SOE_{0j}$. Naturellement, la double itération pourrait être effectuée de manière similaire en imposant chacune des $n_{soe}$ valeurs $SOE_{0j}$ étant itérée pour chacune des $n_p$ valeurs $P_{di}$. Selon une autre alternative, l'ensemble de ces $n_p \cdot n_{soe}$ combinaisons possibles peuvent être obtenues dans un ordre quelconque, organisé ou non. Il faut bien noter que ces $n_p \cdot n_{soe}$ couples peuvent présenter des pas réguliers ou non réguliers.

Selon une variante de réalisation, l'algorithme précédent pourrait être implémenté sans prendre en compte tous les $n_p \cdot n_{soe}$ couples mais un échantillon choisi. Par exemple, dans certaines zones où la batterie présente un comportement stable, il serait possible de ne réaliser la mesure que pour un pas sur deux ou sur trois, et effectuer plus de mesures dans des zones plus délicates de fonctionnement de la batterie, soit pour tous les couples de valeurs dans ces zones.

Les valeurs recherchées peuvent être obtenues par toute modélisation, et à partir des valeurs mesurées, par extrapolation ou interpolation ou par tout traitement mathématique.

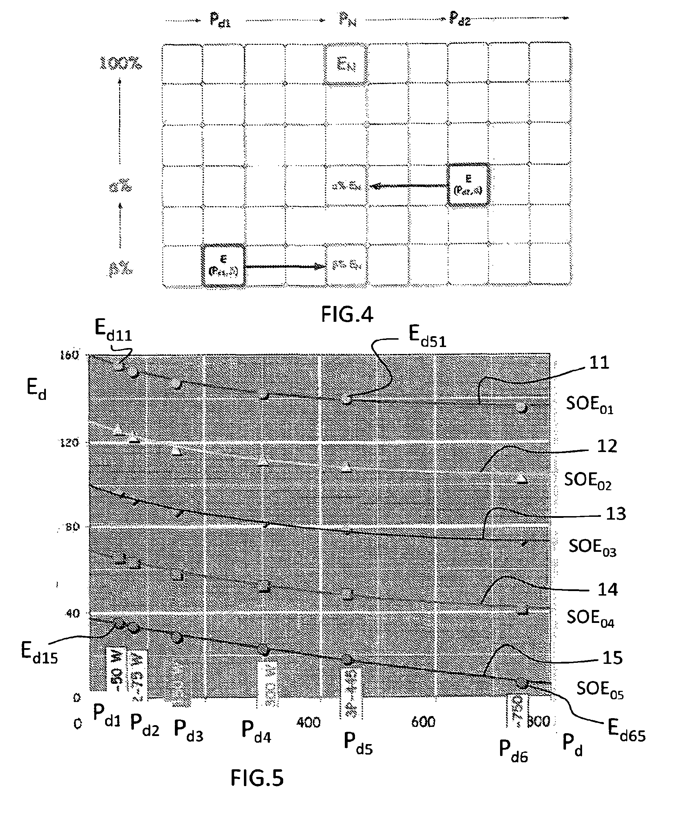

A titre d'exemple avantageux, une extrapolation à partir d'une relation mathématique explicite entre l'énergie disponible $E_d$, la puissance de décharge $P_d$ et l'état d'énergie $SOE_0$ grâce à une régression est mise en oeuvre. La figure 4 illustre ce principe.

Pour cela, dans le cas d'un accumulateur Lithium-ion, la dépendance de l'énergie disponible $E_d$ à la puissance de décharge Pd est dissociée de l'énergie $E_d$ disponible à l'état d'énergie initial.

Ainsi, il est possible d'établir une première dépendance de l'énergie $E_d$ à la puissance de décharge $P_d$ pour chaque état de charge $SOE_{0j}$ par l'intermédiaire d'une régression de type exponentiel ou puissance.

Par exemple, cette régression peut s'écrire par la formule de type exponentiel suivante :

$$E_{d\,SOEoj} = a_j + b_j \cdot \exp(-T_j\,P_d)$$ où $a_j$, $b_j$, $T_j$ sont des paramètres de la régression exponentielle.

En variante, la régression peut s'écrire par la formule de type puissance suivante :

$$E_{d\,SOEoj} = K_j / P_d^{(nj-1)}$$ où $K_j$ et $n_j$ ($n_j > 1$) sont les paramètres de la régression en puissance.

La seconde dépendance de l'énergie $E_d$ à l'état initial $SOE_0$ peut s'exprimer par des régressions linéaires, ou linéaires par morceaux, à partir des paramètres de la régression précédente en fonction de l'état d'énergie initial. Ainsi, dans le cas de la régression exponentielle envisagée précédemment dans le cadre de la première dépendance de l'énergie $E_d$, les paramètres $a_j$, $b_j$, $T_j$ peuvent s'exprimer de la manière linéaire suivante :

$$a_j = \alpha_a \times SOE_0 + \beta_a$$

$$b_j = \alpha_b \times SOE_0 + \beta_b$$

$$T_j = \alpha_T \times SOE_0 + \beta_T$$

avec $\alpha_a$, $\beta_a$, $\alpha_b$, $\beta_b$, $\alpha_T$, $\beta_T$ comme paramètres des régressions linéaires.

Ainsi, une régression permettant d'établir une relation analytique de l'énergie disponible en fonction de la puissance de décharge et de l'état initial peut être pour un accumulateur Lithium-ion :

$$E_d = a_j (SOE_0) + b_j (SOE_0) \, . \, \exp [-T_j (SOE_0) P_d]$$

Où $a_j$ , $b_j$, $T_j$ sont des fonctions linéaires ou linéaires par morceaux dépendant de l'état d'énergie initial.

La figure 5 présente un exemple de cette mise en oeuvre avec une régression exponentielle selon la puissance de décharge $P_d$ représentée en abscisse et des régressions linéaires selon $SOE_0$ pour un accumulateur de 3,7 V et de 147,1 Wh nominal ($P_N$ = 150 W). Les points $E_{dij}$ représentent les différentes valeurs d'énergie issues de l'expérimentation pour différentes puissances $P_{di}$ et à partir de différents états d'énergie $SOE_{0j}$. En remarque, sur l'exemple illustré sur la figure 5, np=6 et $n_{soe}$=5, le graphe représente en ordonnée l'énergie $E_d$ disponible pour une puissance de décharge donnée et le procédé de calibration permet d'obtenir cinq courbes 11 à 15 correspondant respectivement à des valeurs d'état d'énergie $SOE_{01}$ à $SOE_{05}$. Ces différentes courbes sont obtenues par extrapolation entre les différents points de mesure d'énergie disponible $E_{dij}$ à partir des modèles tels qu'explicités précédemment.

Le procédé de calibration précédent permet la mise en oeuvre d'un procédé d'estimation de l'énergie disponible d'un accumulateur électrochimique, par exemple par un algorithme itératif, lors de son utilisation dans un système. Il est possible d'indiquer l'état d'énergie lors de l'utilisation de l'accumulateur à puissance imposée.

Pour cela, un système ou un dispositif intégrant un tel accumulateur peut utiliser des moyens logiciels et/ou matériels (software et/ou hardware), comprenant par exemple une mémoire intégrant les données de calibration définies par le procédé de calibration précédent, et des calculs en temps réel pour connaître précisément le bilan énergétique du système ou du dispositif. Cette approche est particulièrement avantageuse pour les utilisations de batteries par exemple à bord d'un véhicule automobile électrique, ou pour un dispositif de stockage d'énergie connecté au réseau, ou pour tout type de système de stockage soumis à des sollicitations en puissance.

Le concept de l'invention est adapté à tout accumulateur électrochimique, au lithium, ou au nickel, ou au plomb par exemple, que ce soit sur l'accumulateur élémentaire (10 Wh), sur des modules d'accumulateurs en série et/ou en parallèle (100 Wh) ou sur des systèmes complets de modules assemblés aussi en série et/ou en parallèle (de l'ordre de kWh voire de MWh).

**Revendications**

1. Procédé de calibration d'un accumulateur électrochimique, ledit procédé comprenant une première phase (P1) de mesures d'au moins une valeur d'énergie disponible ($E_d$), comprenant une première étape (E1) de détermination d'au moins une valeur de puissance de décharge ($P_d$) et une seconde étape (E2) de détermination d'au moins une valeur d'état d'énergie initial ($SOE_0$) pour laquelle des mesures de calibration de l'énergie disponible sont à effectuer, ledit procédé comprenant une seconde phase (P2) de modélisation de l'énergie disponible ($E_d$) dans l'accumulateur électrochimique représentant l'énergie qui serait obtenue lors d'une décharge complète de l'accumulateur à partir d'une puissance de décharge donnée et d'un état initial d'énergie donné,

**caractérisé en ce que** la première phase (P1) de mesures d'au moins une valeur d'énergie disponible ($E_d$) comprend :

- une première étape (E1) de détermination d'un nombre ($n_p$) de valeurs de puissance de décharge ($P_{di}$) supérieur à un ; et
- une seconde étape (E2) de détermination d'un nombre ($n_{soe}$) de valeurs d'états d'énergie initial ($SOE_{0j}$) supérieur à un ; et
- une troisième étape (E3) de mesures de valeurs d'énergie disponible dans l'accumulateur électrochimique comprenant la mise en oeuvre des sous-étapes suivantes, répétées successivement pour chacune des $n_{soe}$ valeurs d'état d'énergie initial ($SOE_{0j}$) choisies :

(E31) : chargement à charge pleine de l'accumulateur ;

(E32) : décharge de l'accumulateur à puissance constante, égale à la puissance nominale ($P_N$) de l'accumulateur prédéterminée, jusqu'à une énergie déchargée définie par la valeur $(1-SOE_{0j}).E_N$ où EN correspond à l'énergie nominale de l'accumulateur;

(E33) : décharge totale de l'accumulateur à puissance constante égale à une puissance de décharge choisie ($P_{di}$) de l'accumulateur ;

(E34) : mesure de l'énergie totale déchargée ($E_{dij}$) lors de l'étape précédente, soit directement, soit à partir du temps de décharge ;

et **en ce que** les sous-étapes précédentes (E31) à (E34) sont réitérées jusqu'à atteindre la mesure pour toutes les $n_p$ valeurs de puissance de décharge ($P_{di}$) prédéfinies, avant la réitération pour une nouvelle valeur d'état d'énergie initial ($SOE_{0j+1}$).

2.  Procédé de calibration d'un accumulateur électrochimique selon la revendication précédente, **caractérisé en ce que** le nombre ($n_p$) de valeurs de puissance de décharge ($P_{di}$) est compris entre 5 et 15 et **en ce que** le nombre ($n_{soe}$) de valeurs d'état d'énergie initial ($SOE_{0j}$) est compris entre 4 et 12.

3.  Procédé de calibration d'un accumulateur électrochimique selon l'une des revendications 1 ou 2, **caractérisé en ce que** les différentes valeurs de puissance de décharge ($P_{di}$) déterminées sont comprises dans une plage de puissance d'utilisation de l'accumulateur électrochimique, incluant une puissance nominale ($P_N$) prédéterminée, et **en ce que** ces différentes valeurs de puissance sont réparties uniformément ou **en ce qu'**elles sont réparties non uniformément, en plus grand nombre vers les fortes et/ou les faibles valeurs.

4.  Procédé de calibration d'un accumulateur électrochimique selon la revendication précédente, **caractérisé en ce qu'**il comprend une période de relaxation d'au moins dix minutes entre les deux premières sous-étapes (E31, E32) puis après la dernière sous-étape (E34).

5.  Procédé de calibration d'un accumulateur électrochimique selon l'une des revendications précédentes, **caractérisé en ce qu'**il comprend une quatrième étape (E4) de détermination de valeurs d'énergie disponible supplémentaires associées à des valeurs supplémentaires de couples de puissance de décharge et d'état d'énergie initial (Pd ; $SOE_o$) de l'accumulateur déduites des valeurs mesurées par extrapolation/intrapolation, lors de la phase de modélisation (P2) de l'énergie disponible.

6.  Procédé de calibration d'un accumulateur électrochimique selon la revendication précédente, **caractérisé en ce qu'**il comprend un calcul d'une énergie disponible ($E_d$) à une puissance de décharge donnée ($P_d$) pour un état d'énergie initial ($SOE_0$) de l'accumulateur par l'intermédiaire d'une régression de type exponentiel ou puissance, selon la formule :

$E_{d\ SOEoj} = a_j + b_j.\ \exp(-T_j\ P_d)$ où $a_j$, $b_j$, $T_j$ sont des paramètres de régression exponentielle,
Ou selon la formule
$E_{d\ SOEoj} = K_j\ /\ P_d^{(nj-1)}$ où $K_j$ et $n_j$ ($n_j$ >1) sont des paramètres de régression de type puissance.

7.  Procédé de calibration d'un accumulateur électrochimique selon la revendication précédente, **caractérisé en ce qu'**il comprend un calcul d'une énergie disponible ($E_d$) à l'état d'énergie initial ($SOE_0$) par une régression linéaire, ou linéaire par morceaux, à partir des paramètres de type exponentiel ou puissance de la régression précédente en fonction de l'état d'énergie initial.

8.  Procédé de calibration d'un accumulateur électrochimique selon la revendication précédente, **caractérisé en ce qu'**il établit le calcul de l'énergie disponible ($E_d$) d'un accumulateur en fonction de la puissance de décharge ($P_d$) et de l'état d'énergie initial ($SOE_0$) par la formule suivante :

$$E_d = a_j (SOE_0) + b_j (SOE_0) . \exp [-\tau_j (SOE_0) P_d]$$

Où $a_j$, $b_j$, $T_j$ sont des fonctions linéaires ou linéaires par morceaux dépendant de l'état d'énergie initial ($SOE_0$).

9. Procédé d'estimation de l'énergie disponible d'un accumulateur électrochimique, **caractérisé en ce qu'**il comprend l'application du procédé de calibration selon l'une des revendications 1 à 8 et la déduction d'une estimation de l'énergie disponible de l'accumulateur électrochimique lors de son utilisation dans un système à partir d'une modélisation établie par le procédé de calibration.

10. Dispositif comprenant au moins un accumulateur électrochimique, **caractérisé en ce qu'**il comprend un moyen d'estimation de l'énergie disponible mettant en oeuvre un procédé selon la revendication précédente.

**Patentansprüche**

1. Verfahren zum Kalibrieren eines elektrochemischen Akkumulators, wobei das Verfahren eine erste Phase (P1) von Messungen wenigstens eines Wertes der verfügbaren Energie ($E_d$) umfasst, die einen ersten Schritt (E1) des Bestimmens wenigstens eines Entladungsleistungswertes ($P_d$) und einen zweiten Schritt (E2) des Bestimmens wenigstens eines Wertes des anfänglichen Energiezustands ($SOE_0$), für den die Kalibrierungsmessung der verfügbaren Energie auszuführen sind, umfasst, wobei das Verfahren eine zweite Phase (P2) der Modellierung der verfügbaren Energie ($E_d$) in dem elektrochemischen Akkumulator umfasst, die die Energie repräsentiert, die bei einer vollständigen Entladung des Akkumulators ausgehend von einer gegebenen Entladungsleistung und von einem gegebenen anfänglichen Energiezustand erhalten worden wäre,
**dadurch gekennzeichnet, dass** die erste Phase (P1) von Messungen wenigstens eines Wertes der verfügbaren Energie ($E_d$) Folgendes umfasst:

- einen ersten Schritt (E1) des Bestimmens einer Anzahl ($n_p$) von Entladungsleistungswerten ($P_{di}$), die größer als eins ist; und
- einen zweiten Schritt (E2) des Bestimmens einer Anzahl ($n_{soe}$) von Werten des anfänglichen Energiezustands ($SOE_{0j}$), die größer als eins ist; und
- einen dritten Schritt (E3) von Messungen von Werten der verfügbaren Energie in dem elektrochemischen Akkumulator, der das Ausführen der folgenden Unterschritte umfasst, die nacheinander für jeden der $n_{soe}$ gewählten Werte des anfänglichen Energiezustands ($SOE_{0j}$) wiederholt werden:

(E31): Laden bis zur vollen Ladung des Akkumulators;
(E32): Entladen des Akkumulators mit konstanter Leistung, die gleich der vorgegebenen Nennleistung ($P_N$) des Akkumulators ist, bis zu einer entladenen Energie, die durch den Wert $(1 - SOE_{0j}) \cdot E_N$ definiert ist, wobei $E_N$ der Nennenergie des Akkumulators entspricht;
(E33): vollständiges Entladen des Akkumulators mit konstanter Leistung, die gleich einer gewählten Entladungsleistung ($P_{di}$) des Akkumulators ist;
(E34) : Messen der gesamten Energie ($E_{dij}$), die im vorhergehenden Schritt entladen wurde, entweder direkt oder anhand der Entladungszeit;
und dass die vorhergehenden Unterschritte (E31) bis (E34) wiederholt ausgeführt werden, bis die Messung für alle der im Voraus definierten $n_p$ Entladungsleistungswerte ($P_{di}$) erreicht ist, bevor die Wiederholung für einen neuen Wert des anfänglichen Energiezustands ($SOE_{0j+1}$) begonnen wird.

2. Verfahren zum Kalibrieren eines elektrochemischen Akkumulators nach dem vorhergehenden Anspruch, **dadurch gekennzeichnet, dass** die Anzahl ($n_p$) von Entladungsleistungswerten ($P_{di}$) im Bereich von 5 bis 15 liegt und dass die Anzahl ($n_{soe}$) von Werten ($SOE_{0j}$) des anfänglichen Energiezustands im Bereich von 4 bis 12 liegt.

3. Verfahren zum Kalibrieren eines elektrochemischen Akkumulators nach einem der Ansprüche 1 oder 2, **dadurch gekennzeichnet, dass** die bestimmten verschiedenen Entladungsleistungswerte ($P_{di}$) in einem Leistungsbereich der Verwendung des elektrochemischen Akkumulators liegen, der eine vorgegebene Nennleistung ($P_N$) enthält, und dass diese verschiedenen Leistungswerte gleichmäßig verteilt sind oder dass sie nicht gleichmäßig verteilt sind, mit einer Häufung bei den großen und/oder kleinen Werten.

4. Verfahren zum Kalibrieren eines elektrochemischen Akkumulators nach dem vorhergehenden Anspruch, **dadurch gekennzeichnet, dass** es zwischen den beiden ersten Unterschritten (E31, E32) und dann nach dem letzten Unterschritt (E34) eine Entspannungsperiode von wenigstens zehn Minuten umfasst.

5. Verfahren zum Kalibrieren eines elektrochemischen Akkumulators nach einem der vorhergehenden Ansprüche, **dadurch gekennzeichnet, dass** es einen vierten Schritt (E4) des Bestimmens zusätzlicher Werte der verfügbaren Energie umfasst, die zusätzlichen Werten von Paaren der Entladungsleistung und des anfänglichen Energiezustands ($P_d$; $SOE_0$) des Akkumulators, die in der Modellierungsphase (P2) der verfügbaren Energie aus den gemessenen Werten durch Extrapolation/Intrapolation abgeleitet werden, zugeordnet sind.

6. Verfahren zum Kalibrieren eines elektrochemischen Akkumulators nach dem vorhergehenden Anspruch, **dadurch gekennzeichnet, dass** es eine Berechnung der verfügbaren Energie ($E_d$) mit einer gegebenen Entladungsleistung ($P_d$) für einen anfänglichen Energiezustand ($SOE_0$) des Akkumulators über eine Regression des exponentiellen Typs oder des Leistungstyps gemäß der folgenden Formel:

$E_{d\ SOE0j} = a_j + b_j \cdot exp(-T_j\ P_d)$, wobei $a_j$, $b_j$, $T_j$ Parameter der exponentiellen Regression sind, oder gemäß der folgenden Formel:

$E_{d\ SOE0j} = K_j/P_d^{(nj-1)}$, wobei $K_j$ und $n_j$ ($n_j > 1$) Parameter der Regression des Leistungstyps sind, umfasst.

7. Verfahren zum Kalibrieren eines elektrochemischen Akkumulators nach dem vorhergehenden Anspruch, **dadurch gekennzeichnet, dass** es eine Berechnung einer verfügbaren Energie ($E_d$) im anfänglichen Energiezustand ($SOE_0$) durch eine lineare Regression oder eine stückweise lineare Regression anhand der Parameter des exponentiellen Typs oder des Leistungstyps der vorhergehenden Regression als Funktion des anfänglichen Energiezustands umfasst.

8. Verfahren zum Kalibrieren eines elektrochemischen Akkumulators nach dem vorhergehenden Anspruch, **dadurch gekennzeichnet, dass** es die Berechnung der verfügbaren Energie ($E_d$) eines Akkumulators als Funktion der Entladungsleistung ($P_d$) und des anfänglichen Energiezustands ($SOE_0$) durch die folgende Formel ausführt:

$$E_d = a_j(SOE_0) + b_j(SOE_0) \cdot exp[-T_j(SOE_0)\ P_d]$$

wobei $a_j$, $b_j$, $T_j$ lineare oder stückweise lineare Funktionen sind, die von dem anfänglichen Energiezustand ($SOE_0$) abhängen.

9. Verfahren zum Schätzen der verfügbaren Energie eines elektrochemischen Akkumulators, **dadurch gekennzeichnet, dass** es die Anwendung des Kalibrierungsverfahrens nach einem der Ansprüche 1 bis 8 und die Ableitung einer Schätzung der verfügbaren Energie des elektrochemischen Akkumulators bei seiner Verwendung in einem System anhand einer durch das Kalibrierungsverfahren ausgeführten Modellierung umfasst.

10. Vorrichtung, die wenigstens einen elektrochemischen Akkumulator umfasst, **dadurch gekennzeichnet, dass** sie ein Mittel zum Schätzen der verfügbaren Energie enthält, das ein Verfahren nach dem vorhergehenden Anspruch ausführt.

**Claims**

1. Method for calibration of an electrochemical accumulator, said method comprising a first phase (P1) of measurements of at least one value of available energy ($E_d$), comprising a first step (E1) for determining at least one value of discharge power ($P_d$) and a second step (E2) for determining at least one value of initial state of energy ($SOE_0$) for which calibration measurements of the available energy are to be carried out, and said method comprising a second phase (P2) for modelling the available energy ($E_d$) of the electrochemical accumulator representing the energy that would be obtained when the accumulator is completely discharged based on a given discharge power and on a given initial state of energy, **characterized in that** the first phase (P1) of measurements of at least one value of available energy ($E_d$) comprises :

- a first step (E1) for determining a number ($n_p$) of values of discharge power ($P_{di}$) greater than one and

- - a second step (E2) for determining a number ($n_{soe}$) of values of initial states of energy ($SOE_{0j}$) greater than one, and

- a third step (E3) for measurement of the value of energy available in the electrochemical accumulator comprising the implementation of the following sub-steps, repeated successively for each of the $n_{soe}$ chosen values of initial state of energy ($SOE_{0j}$):

(E31): charging to full charge of the accumulator;

(E32): discharge of the accumulator at constant power, equal to the predetermined nominal power ($P_N$) of the accumulator, until a discharged energy defined by the value $(1-SOE_0).E_N$ is reached,

where $E_N$ corresponds to the nominal energy of the accumulator;

(E33): total discharge of the accumulator at constant power equal to a chosen discharge power ($P_d$) of the accumulator;

(E34): measurement of the total energy discharged ($E_d$) during the preceding step, either directly or from the discharge time;

And **in that** the preceding sub-steps (E31) to (E34) are iterated until the measurement is reached for all the predefined $n_p$ values of discharge power ($P_{di}$), before the re-iteration for a new value of initial state of energy ($SOE_{0j+1}$).

2. Method for calibration of an electrochemical accumulator according to the preceding claim, **characterized in that** the number ($n_p$) of values of discharge power ($P_{di}$) is in the range between 5 and 15 and **in that** the number ($n_{soe}$) of values of initial state of energy ($SOE_{0j}$) is in the range between 4 and 12.

3. Method for calibration of an electrochemical accumulator according to Claim 1 or 2, **characterized in that** the various values of discharge power ($P_{di}$) determined are included in a range of power of use of the electrochemical accumulator, including a predetermined nominal power ($P_N$), and **in that** these various power values are distributed uniformly or **in that** they are distributed non-uniformly, with a greater number towards the high and/or the low values.

4. Method for calibration of an electrochemical accumulator according to the preceding claim, **characterized in that** it comprises a relaxation period of at least ten minutes between the first two sub-steps (E31, E32) then after the last sub-step (E34).

5. Method for calibration of an electrochemical accumulator according to one of previous claims, **characterized in that** it comprises a fourth step (E4) for determining additional values of available energy associated with additional values of pairs of discharge power and initial state of energy (Pd; $SOE_0$) of the accumulator deduced from the measured values by extrapolation/interpolation during the phase (P2) for modelling the available energy.

6. Method for calibration of an electrochemical accumulator according to the preceding claim, **characterized in that** it comprises a calculation of available energy ($E_d$) at a given discharge power ($P_d$) for an initial state of energy ($SOE_0$) of the accumulator by means of a regression of the exponential or power type, according to the formula:

$E_{d\ SOEoj} = a_j + b_j \cdot exp(-T_j\ P_d)$ where $a_j$, $b_j$, $T_j$ are exponential regression parameters,
or according to the formula
$E_{d\ SOEoj} = K_j / P_d^{(nj-1)}$ where $K_j$ and $n_j$ ($n_j >1$) are parameters for a regression of the power type.

7. Method for calibration of an electrochemical accumulator according to the preceding claim, **characterized in that** it comprises a calculation of available energy ($E_d$) at the initial state of energy ($SOE_0$) by a linear regression, or regression in linear sections, using the parameters of the exponential or power type of the preceding regression as a function of the initial state of energy.

8. Method for calibration of an electrochemical accumulator according to the preceding claim, **characterized in that** it establishes the calculation of the available energy ($E_d$) of an accumulator as a function of the discharge power ($P_d$) and of the initial state of energy ($SOE_0$) by the following formula:

$$E_d = a_j (SOE_0) + b_j (SOE_0) \cdot exp [-\tau_j (SOE_0) P_d]$$

where $a_j$, $b_j$, $T_j$ are linear functions, or functions in linear sections, depending on the initial state of energy ($SOE_0$).

9. Method for estimating the available energy of an electrochemical accumulator, **characterized in that** it comprises the application of the calibration method according to one of Claims 1 to 8 and the deduction of an estimation of the available energy in the electrochemical accumulator when used in a system on the basis of a modelling established by the calibration method.

10. Device comprising at least one electrochemical accumulator, **characterized in that** it comprises a means for estimating the available energy implementing a method according to the preceding claim.

A1

2

1

**FIG.1**

A2

P1

P2

1

**FIG.2**

FIG.3

FIG.4

FIG.5

## RÉFÉRENCES CITÉES DANS LA DESCRIPTION

**Documents brevets cités dans la description**

- US 5650712 A
- US 6300763 B1
- WO 0242786 A2